# DEMANDE DE BREVET EUROPEEN

(11) **EP 1 312 895 A1**
(43) Date de publication de la demande: **21.05.2003**
(21) Numéro de dépôt: 02292835.2
(22) Date de dépôt: 14.11.2002
(51) Int. Cl.: G01D 5/165, G01D 5/25

(54) **Circuit imprimé pour codeur angulaire analogique**

(30) Priorité: 14.11.2001 FR 0114726
(71) Demandeur: CROUZET APPLIANCE CONTROLS, F-26120 Montelier Chabeuil (FR)
(72) Inventeur: Boilley, Michel, 26120 Chabeuil (FR)
(74) Mandataire: Geismar, Thierry

(57) **Abrégé**

L'invention concerne un circuit imprimé pour codeur angulaire analogique (1), du type comprenant au moins une piste résistive (2, 2') et un balai (11) associé à cette piste résistive (2, 2'), ladite piste (2, 2') comprenant au moins un ensemble de plages résistives (5, 5') réalisées par dépôt d'une encre résistive par sérigraphie, lesdites plages résistives (5, 5') étant reliées à des plots (6) de prélèvement de tension, ledit ensemble de plages résistives (5, 5') s'étendant sensiblement le long d'une droite.

## Description

L'invention concerne un circuit imprimé pour codeur angulaire analogique, du type comprenant au moins une piste résistive et un balai associé à cette piste.

On utilise notamment ce type de codeur dans des systèmes associant une partie mécanique et une partie électronique, tels que des programmateurs de machine à laver, dans lesquels l'électronique de traitement doit pouvoir connaître économiquement, par lecture directe, la position angulaire d'un axe rotatif avec une précision donnée, allant, par exemple, de 10 à 60 positions par tour.

Par « lecture directe », on entend la possibilité de reconnaître la position de l'axe pratiquement instantanément, ce qui exclut les systèmes fonctionnant par lecture incrémentale, c'est-à-dire par addition d'incréments depuis une position d'origine.

Ce type de codeur comprend généralement deux pistes concentriques, l'une résistive, à l'extérieur, et l'autre conductrice, à l'intérieur. Un balai, dont on veut mesurer la position angulaire, est monté mobile en rotation autour du centre de ces deux pistes, et relie deux points homologues de chacune des pistes.

La piste résistive présente deux extrémités, sur lesquelles on peut appliquer une tension de référence. Ainsi, lorsqu'on applique une différence de potentiel de référence entre les deux extrémités de la piste résistive, la tension recueillie sur la piste conductrice est proportionnelle à la position angulaire du balai.

On connaît déjà, notamment du document FR-2 761 795, un tel codeur dont la piste résistive comprend un ensemble de plages résistives dont les interconnexions sont reliées à des plots de prélèvement de tension.

Dans ce type de codeur, les plages résistives sont disposées de façon circulaire, autour des plots de prélèvement de tension. Cependant, lors de la mise en oeuvre du procédé de sérigraphie visant à imprimer la piste résistive, le passage de la racle induit la formation de plages résistives présentant des valeurs de résistance sensiblement différentes les unes des autres, en fonction de leur orientation par rapport à la racle.

Pour remédier à cet inconvénient, l'invention propose un circuit imprimé pour codeur angulaire analogique dont les plages résistives ont toutes les mêmes valeurs de résistance, induisant ainsi une meilleure linéarité.

A cet effet, l'invention propose selon un premier aspect un circuit imprimé pour codeur angulaire analogique, du type comprenant au moins une piste résistive et un balai associé à cette piste résistive, ladite piste comprenant au moins un ensemble de plages résistives réalisées par dépôt d'une encre résistive par sérigraphie, lesdites plages résistives étant reliées à des plots de prélèvement de tension, ledit ensemble de plages résistives s'étendant sensiblement le long d'une droite.

Selon un mode de réalisation, le circuit comprend deux ensembles parallèles comprenant des plages résistives s'étendant suivant la même direction.

Selon un mode de réalisation, ledit circuit comprend des moyens pour amener les extrémités des deux pistes résistives à un premier et à un deuxième potentiel respectivement, des moyens pour amener un autre point à un troisième potentiel, des moyens pour moduler au moins ledit premier ou deuxième potentiel, ledit troisième potentiel étant fixe, et des moyens pour lire le potentiel du point de la piste résistive au contact du balai.

Suivant ce mode de réalisation, l'un desdits premier ou deuxième potentiel du circuit est fixe.

En variante, l'un au moins desdits premier ou deuxième potentiels du circuit est modulé en créneaux.

En outre, ledit autre point dudit circuit peut être sensiblement au milieu des deux pistes résistives.

Plus particulièrement, ledit circuit peut comprendre une piste conductrice concentrique au cercle de plots, le balai reliant un point de la piste résistive à la piste conductrice, et le potentiel du point de la piste résistive au contact du balai étant lu sur la piste conductrice.

Selon un deuxième aspect, l'invention concerne un codeur analogique angulaire comprenant un tel circuit imprimé.

D'autres objets et avantages de l'invention apparaîtront au cours de la description qui suit, faite en référence aux dessins annexés dans lesquels :
- la figure 1 représente schématiquement une vue de dessus d'un circuit imprimé servant de base au codeur selon un mode de réalisation ; et
- la figure 2 représente schématiquement un tel codeur comprenant un bouton de commande et un curseur.

Le support servant de base au codeur 1 selon l'invention est un support plastique dur ou souple pouvant être sérigraphié avec des encres conductrices ou résistives. Le circuit qui sera décrit ci-après est gravé sur ce support.

Ce circuit comprend deux pistes résistives 2 et 2' présentant chacune deux extrémités 3, 3' et 4, 4'. Chaque piste 2, 2' est formée d'un ensemble de plages résistives adjacentes 5, 5' réalisées par dépôt d'une encre carbone résistive par sérigraphie. Ces plages résistives 5, 5' présentent chacune une résistance élémentaire R dans la direction de la piste 2, 2'.

Les extrémités des plages résistives 5, 5' et des plots de prélèvement de tension 6 sont reliés électriquement par des pistes de cuivre gravées 7.

Les plots de prélèvement 6 sont disposés en cercle.

Les pistes de cuivre 7 sont connectées transversalement à la piste 2, 2', à des points équidistants 8.

Selon le mode de réalisation représenté, les plots 6 sont réalisés par sérigraphie, par dépôt d'une encre résistive ou conductrice.

Pour obtenir un codeur 1 présentant une linéarité optimale, il est nécessaire que toutes les plages résistives 5, 5' aient une même valeur de résistance R.

A cet effet, il est prévu selon l'invention que les ensembles de plages résistives 5, 5', à savoir les pistes 2, 2', s'étendent sensiblement le long d'une droite. Ainsi, lors de la mise en oeuvre du procédé de sérigraphie à la racle, toutes les plages résistives sont isotropes suivant la direction de la racle, induisant de la sorte des résistances élémentaires R de valeur identique.

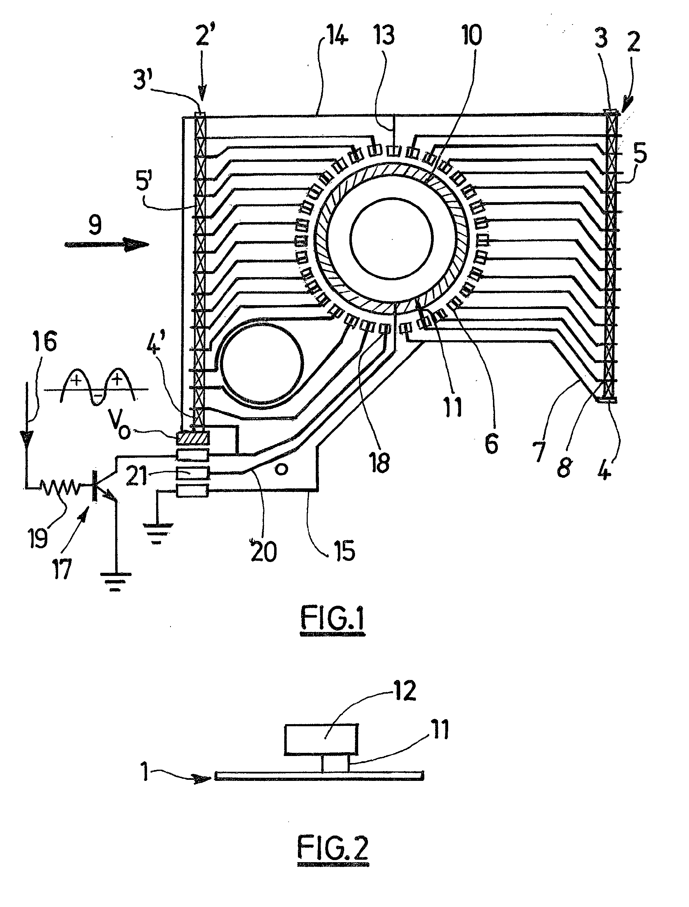

Selon le mode de réalisation représenté sur la figure 1, la racle est passée dans le sens de la flèche 9.

En outre, selon un mode de réalisation, une piste conductrice 10 est réalisée concentriquement au cercle de plots 6. Cette piste conductrice 10 est en encre carbone sérigraphiée sur piste de cuivre gravée.

Un balai 11, représenté sur la figure 2 associé à un moteur 12, dont la position angulaire doit être mesurée, est monté rotatif au centre de la piste 10. Ce balai 11 relie le plot 6 correspondant à cette position à la piste conductrice 10.

Le potentiel du point de la piste résistive 2, 2' au contact du balai 13 est par conséquent lu sur la piste conductrice 10.

Selon l'exemple représenté, le balai peut prendre 32 positions correspondant à 32 plots et à 31 plages résistives.

Selon un mode de réalisation particulier, le point médian 13 est relié à la tension d'alimentation V₀ par une ligne 14, et les deux extrémités 3 et 3' des pistes résistives 2 et 2' sont reliées à la masse. Ainsi, les deux pistes résistives 2 et 2' se trouvent alimentées par la tension V₀, par exemple égale à 5 Volts.

En conséquence, à une lecture de potentiel donnée correspondent deux positions angulaires possibles. La discrimination est faite par les modulations différentes que l'on relève selon que le curseur se trouve sur l'une ou l'autre des deux pistes 2, 2'.

Suivant le mode de réalisation représenté, l'extrémité 4 de la piste 2 est reliée à la masse par une ligne 15. L'extrémité 4' est reliée à une tension alternative, ici le secteur 16, par l'intermédiaire d'un interrupteur 17.

L'interrupteur 17 est constitué d'un transistor dont le collecteur est relié au point 18, dont l'émetteur est relié à la masse, et dont la base est reliée au secteur par l'intermédiaire d'une résistance 19.

La piste conductrice 10 est reliée par l'intermédiaire d'une ligne 20 à l'entrée analogique d'un microcontrôleur 21.

Si l'on suppose l'interrupteur 17 fermé, on constate qu'on lit la même tension, continue, sur deux plots 6 symétriques par rapport au point 13.

Toutefois, l'interrupteur 17 n'est pas fermé en permanence puisque la base du transistor est alternativement portée à des tensions positives puis négatives. Le transistor est donc alternativement saturé puis bloqué. Il en résulte que la tension lue sur les plots 6 situés, sur la figure 1, à la gauche du point médian 13, est modulée en créneaux.

Par conséquent, le microcontrôleur 21 saura reconnaître sur quelle piste résistive 2 ou 2' se trouve le balai 11, par la forme de la tension relevée sur la piste conductrice 10.

On obtient ainsi une définition double de ce qu'elle aurait été en portant simplement le point 18 au potentiel V₀.

Selon ce mode de réalisation, le circuit comprend ainsi deux pistes résistives 2, 2' composée chacune d'un ensemble de plages résistives 5, 5', les deux ensembles étant parallèles.

De la sorte, on obtient une pièce à haute symétrie, sur laquelle la disposition des plages résistives est agencée pour obtenir une très haute précision de mesure.

Le codeur contenant le circuit imprimé selon l'invention possède par conséquent une linéarité optimale permettant d'atteindre les niveaux de définition angulaire souhaités.

## Revendications

1. Circuit imprimé pour codeur angulaire analogique (1), du type comprenant au moins une piste résistive (2, 2') et un balai (11) associé à cette piste résistive (2, 2'), ladite piste (2, 2') comprenant au moins un ensemble de plages résistives (5, 5') réalisées par dépôt d'une encre résistive par sérigraphie, lesdites plages résistives (5, 5') étant reliées à des plots (6) de prélèvement de tension, **caractérisé en ce que** ledit ensemble de plages résistives (5, 5') s'étend sensiblement le long d'une droite.

2. Circuit selon la revendication 1, **caractérisé en ce qu'**il comprend deux ensembles parallèles comprenant des plages résistives (5, 5') s'étendant suivant la même direction.

3. Circuit selon l'une des revendications 1 ou 2, **caractérisé en ce que** les plages résistives (5, 5') et les plots (6) correspondants sont reliés électriquement par des pistes de cuivre gravées (7).

4. Circuit selon l'une quelconque des revendications 1 à 3, **caractérisé en ce que** les plots (6) sont réalisés par sérigraphie.

5. Circuit selon l'une quelconque des revendications 1 à 4, **caractérisé en ce qu'**il comprend des moyens (15, 16) pour amener les extrémités (4, 4') des deux pistes résistives (2, 2') à un premier et à un deuxième potentiel respectivement, des moyens (14) pour amener un autre point (13) à un troisième potentiel, des moyens (17) pour moduler au moins ledit premier ou deuxième potentiel, ledit troisième potentiel étant fixe, et des moyens (10, 20, 21) pour lire le potentiel du point de la piste résistive au contact du balai (11).

6. Circuit selon la revendication 5, **caractérisé en ce que** l'un desdits premier ou deuxième potentiel est fixe.

7. Circuit selon la revendication 5 ou 6, **caractérisé en ce que** l'un au moins desdits premier ou deuxième potentiels est modulé en créneaux.

8. Circuit selon l'une quelconque des revendications 5 à 7, **caractérisé en ce que** ledit autre point (13) est sensiblement au milieu des deux pistes résistives (2, 2').

9. Circuit selon l'une quelconque des revendications 5 à 8, **caractérisé en ce qu'**il comprend une piste conductrice (10) concentrique au cercle de plots (6), le balai (11) reliant un point de la piste résistive (2, 2') à la piste conductrice (10), et le potentiel du point de la piste résistive (2, 2') au contact du balai (11) étant lu sur la piste conductrice (10).

10. Codeur analogique angulaire comprenant un circuit imprimé selon l'une quelconque des revendications 1 à 9.
